# EUROPEAN PATENT APPLICATION

(11) **EP 4 636 475 A1**
(43) Date of publication of application: **22.10.2025**
(21) Application number: 23914426.4
(22) Date of filing: 23.11.2023
(51) Int. Cl.: G03B 21/14, G03B 21/16, H04N 9/31

(54) **HOUSING, PROJECTION DEVICE, AND METHOD USED FOR PROJECTING DEVICE**

(30) Priority: 03.01.2023 CN 202310004551
(71) Applicant: Shenzhen Roborock Innovation Technology Co., Ltd., Shenzhen, Guangdong 518000 (CN); Beijing Roborock Technology Co., Ltd., Beijing 102206 (CN)
(72) Inventor: LU, Zehui, Beijing 102206 (CN); YU, Guang, Beijing 102206 (CN); ZHU, Dehui, Beijing 102206 (CN); WANG, Qilin, Beijing 102206 (CN); ZHOU, Qiang, Beijing 102206 (CN); CHEN, Jiabo, Beijing 102206 (CN); YANG, Guangzhen, Beijing 102206 (CN); YU, Yihui, Beijing 102206 (CN); YUAN, Jiabo, Beijing 102206 (CN)
(74) Representative: Manitz Finsterwald Patent- und Rechtsanwaltspartnerschaft mbB
(86) International application number: PCT/CN2023/133582
(87) International publication number: WO 2024/146291

(57) **Abstract**

A housing, a projection device, and a method used for a projection device. The projection device (10) comprises an optical engine assembly (200), wherein the optical engine assembly (200) has a first structure or a second structure, the second structure being different from the first structure. The housing comprises a main body structure (121) for defining the appearance of the projection device, and an optical-engine fixing structure (122), wherein with regard to the optical engine assembly (200), which has the first structure or the second structure, the main body structure (121) is the same; the optical-engine fixing structure (122) comprises at least one optical-engine fastening component (130); and the position and/or size of the at least one optical-engine fastening component (130) on the optical-engine fixing structure (122) is configured, according to the optical engine assembly (200) having the first structure, to be suitable for mounting at least part of the optical engine assembly (200) having the first structure on the housing, or is configured, according to the optical engine assembly (200) having the second structure, to be suitable for mounting at least part of the optical engine assembly (200) having the second structure on the housing. By means of the solution, a housing with the same appearance can be compatible with different models of optical engine assemblies at relatively low costs.

## Description

### CROSS-REFERENCE TO RELATED APPLICATION

The present disclosure claims priority to Chinese Patent Application No. 202310004551.4, filed in China on January 3, 2023, which is incorporated herein by reference in its entirety.

### TECHNICAL FIELD

The present disclosure relates to the field of projection display technologies, and in particular, to a housing of a projection device, a projection device, and a method for a projection device.

### BACKGROUND

In recent years, projection devices have been widely used. In addition to achieving the function of projecting images, some smart projection devices can also achieve functions such as music playing and voice interaction. Currently, there are at least the following improvement requirements for a projection device:
1) The housing of a projection device can only adapt to an optical module assembly of a specific model, but cannot be compatible with optical module assemblies of other models. This results in the need to produce a variety of corresponding housings, or a large number of components need to be replaced during production or maintenance to adapt the housing to other models of optical module assemblies. Therefore, a solution that can achieve compatibility between the housing and a plurality of models of optical module assemblies at a low cost is needed.
2) Projection devices such as a speaker module and an optical module assembly are all mounted onto the lower housing, and vibration generated during the operation of the speaker module is transmitted to the optical module assembly through the lower housing, causing the projected image to shake, thereby significantly affecting the projection effect. Especially for an ultra-short-throw projection device, small vibration of the optical module assembly can cause a large shake of the projection picture, resulting in a blurry picture. When the speaker module plays low-frequency audio data, the optical module assembly experiences more pronounced vibration. Therefore, a solution to effectively alleviate the impact of the vibration of the speaker module on the optical module assembly is needed.
3) During use, direct viewing of the optical module by human eyes may cause eye damage. Especially children, out of curiosity, may intentionally look directly at the light source of the optical module. Therefore, to protect human eyes, the projection device needs to have an anti-direct-viewing function. However, in the related art, the anti-direct-viewing function has a small detection range and a poor anti-direct-viewing effect, and the existing sensor cannot be reused, resulting in problems such as high costs and waste of resources. Therefore, an improved anti-direct-viewing solution is needed, which can accurately, quickly, and reliably determine whether there is a risk of direct viewing by human eyes, and immediately reduce the brightness of the optical module or even turn off the optical module.
4) The projection device is often provided with a plurality of heat dissipation fans to reduce the temperature throughout the projection device. However, the arrangement of the plurality of fans results in many problems such as high costs and high noise. In addition, a complex heat dissipation structure affects the normal operation of the projection device. Therefore, a concise and efficient heat-dissipation layout solution is needed.

### SUMMARY

According to a first aspect of embodiments of the present disclosure, a housing for a projection device is provided. The projection device includes an optical module assembly, the optical module assembly is provided with a first structure or a second structure, and the second structure is different from the first structure. The housing includes:
a main body structure, defining an outer shape of the projection device, where for the optical module assembly provided with the first structure or the second structure, the main body structure of the housing is the same; and
an optical module fixing structure, where the optical module fixing structure includes at least one optical module fastening component, and a position and/or a dimension of the at least one optical module fastening component on the optical module fixing structure is configured to:
   be suitable for mounting at least a part of the optical module assembly provided with the first structure onto the housing according to the optical module assembly provided with the first structure; or
   be suitable for mounting at least a part of the optical module assembly provided with the second structure onto the housing according to the optical module assembly provided with the second structure.

In some embodiments, the projection device further includes an optical module support, and the optical module support is configured to be suitable for mounting at least a part of the optical module assembly provided with the first structure or the second structure; the housing further includes:
an optical module support fixing structure, where the optical module support fixing structure includes at least one optical module support fastening component, and a position and/or a dimension of the at least one optical module support fastening component on the optical module support fixing structure is configured to be suitable for mounting the optical module support onto the housing.

In some embodiments, the optical module assembly includes a lens portion and a light source portion opposite to the lens portion, where the at least one optical module fastening component is configured to mount the lens portion onto the optical module fixing structure, and where the light source portion is mounted on the optical module support.

In some embodiments, the at least one optical module fastening component and/or the at least one optical module support fastening component includes a threaded hole.

In some embodiments, the housing is a lower housing of the projection device.

In some embodiments, the housing is integrally formed by injection molding with a mold.

According to a second aspect of the embodiments of the present disclosure, a housing for a projection device is provided. The projection device includes an optical module assembly, the optical module assembly is provided with a first structure or a second structure, and the second structure is different from the first structure. The housing is formed by injection molding with a mold, the mold includes a mold main body and a set of mold inserts capable of being embedded into the mold main body, and the housing includes:
a main body structure, defining an outer shape of the projection device and injection molded by using the mold main body, where for the optical module assembly provided with the first structure or the second structure, the main body structure is injection molded by using the same mold main body; and
an optical module fixing structure, where the optical module fixing structure includes at least one optical module fastening component to mount at least a part of the optical module assembly onto the housing, and the optical module fixing structure is injection molded by using the mold insert; and where for the optical module assembly provided with the first structure or the second structure, the optical module fixing structure is injection molded by using different mold inserts of the set of mold inserts, such that a position and/or a dimension of the at least one optical module fastening component that is injection molded on the optical module fixing structure is configured to:
   be suitable for mounting at least a part of the optical module assembly provided with the first structure onto the housing according to the optical module assembly provided with the first structure; or
   be suitable for mounting at least a part of the optical module assembly provided with the second structure onto the housing according to the optical module assembly provided with the second structure.

According to a third aspect of the embodiments of the present disclosure, a projection device is provided. The projection device includes:
the housing according to the first aspect and the second aspect; and
an optical module assembly mounted onto the housing.

According to a fourth aspect of the embodiments of the present disclosure, a method for manufacturing a housing for a projection device is provided. The projection device includes an optical module assembly, the housing includes a main body structure and an optical module fixing structure, and the optical module fixing structure includes at least one optical module fastening component to mount at least a part of the optical module assembly onto the housing. The method includes:
providing a mold main body for injection molding the main body structure of the housing;
selecting a mold insert for injection molding the optical module fixing structure according to a structure of the optical module assembly to be mounted onto the housing, where the mold insert is configured such that, when embedded into the mold main body, a position and/or a dimension of the at least one optical module fastening component that is injection molded on the optical module fixing structure is configured to be suitable for mounting the optical module assembly onto the housing;
embedding the selected mold insert into the mold main body to form an integral mold; and
injection molding the housing through the integral mold.

In some embodiments, the optical module assembly is provided with a first structure or a second structure, and the second structure is different from the first structure; providing the mold main body for injection molding the main body structure of the housing, includes:
for the optical module assembly provided with the first structure or the second structure, providing a same mold main body for injection molding the main body structure of the housing.

In some embodiments, the optical module assembly is provided with a first structure or a second structure, and the second structure is different from the first structure; selecting the mold insert for injection molding the optical module fixing structure, includes:
selecting a first mold insert according to the optical module assembly provided with the first structure, where the first mold insert is configured such that, when embedded into the mold main body, a position and/or a dimension of the at least one optical module fastening component that is injection molded on the optical module fixing structure is configured to be suitable for mounting the optical module assembly provided with the first structure onto the housing; or
selecting a second mold insert according to the optical module assembly provided with the second structure, where the second mold insert is configured such that, when embedded into the mold main body, a position and/or a dimension of the at least one optical module fastening component after injection molding on the optical module fixing structure is configured to be suitable for mounting the optical module assembly provided with the second structure onto the housing.

According to a fifth aspect of the embodiments of the present disclosure, a projection device is provided. The projection device includes:
a housing assembly, where the housing assembly includes an upper housing and a lower housing, and the upper housing and the lower housing are detachably connected together;
an optical module assembly, where the optical module assembly is mounted onto the lower housing and separated from the upper housing; and
a speaker module, where the speaker module is mounted onto the upper housing and separated from the lower housing.

In some embodiments, the upper housing is provided with a speaker buffer pad and a fastener, and the fastener mounts the speaker module onto the upper housing via the speaker buffer pad, such that the speaker module is spaced apart from the upper housing by the speaker buffer pad.

In some embodiments, a lower housing buffer pad is disposed on an outer surface of the lower housing.

In some embodiments, an elastic sealing member is disposed between the upper housing and the lower housing.

In some embodiments, the optical module assembly is provided with a counterweight.

In some embodiments, the speaker module includes a speaker main body and at least one passive low-frequency radiator.

In some embodiments, the speaker module includes two passive low-frequency radiators disposed on left and right sides of the speaker main body, respectively.

According to a sixth aspect of the embodiments of the present disclosure, a method for a projection device is provided. The projection device includes: an optical module assembly, where the optical module assembly includes a light outlet for emitting projection light; and a first perception sensor and a second perception sensor. The method includes:
detecting, via the first perception sensor, whether an object appears in a first area in front of the light outlet;
detecting, via the second perception sensor, whether an object appears in a second area in front of the light outlet, where the first area is different from the second area; and
determining, based on a signal detected by at least one of the first perception sensor and the second perception sensor, an adjustment of projection of the optical module assembly.

In some embodiments, at least one of the first perception sensor and the second perception sensor includes one of an image acquisition unit, a single-point time-of-flight (TOF) sensor, a multi-point TOF sensor, and a passive infrared (PIR) sensor.

In some embodiments, at least one of the first perception sensor and the second perception sensor includes a single-point TOF sensor; determining, based on a signal detected by the single-point TOF sensor, the adjustment of the projection of the optical module assembly, includes:
determining, in response to the detected signal being less than a threshold, that the object is detected, where the detected signal is a distance between the single-point TOF sensor and the object; and
controlling, in response to detecting the object, the optical module assembly to reduce a light intensity of the emitted projection light.

In some embodiments, at least one of the first perception sensor and the second perception sensor includes a multi-point TOF sensor; determining, based on a signal detected by the multi-point TOF sensor, the adjustment of the projection of the optical module assembly, includes:
fitting a plane based on a point cloud formed by the detected signal;
calculating a distance from the point cloud to the fitted plane;
determining, in response to the distance being greater than a threshold, that the object is detected; and
controlling, in response to detecting the object, the optical module assembly to reduce a light intensity of the emitted projection light.

In some embodiments, at least one of the first perception sensor and the second perception sensor includes an image acquisition unit; determining, based on a signal detected by the image acquisition unit, the adjustment of the projection of the optical module assembly, includes:
performing frame synchronization with a projection picture of the optical module through a timestamp;
acquiring an image through the image acquisition unit and obtaining an optical module projection image at a corresponding time;
determining, in response to a difference between the image acquired by the image acquisition unit and the optical module projection image at the corresponding time being greater than a threshold, that the object is detected; and
controlling, in response to detecting the object, the optical module assembly to reduce a light intensity of the emitted projection light.

In some embodiments, determining the adjustment of the projection of the optical module assembly, includes:
determining, based on the signal detected by the at least one of the first perception sensor and the second perception sensor, a confidence that at least one of the first perception sensor and the second perception sensor detects the object;
determining, according to a position of at least one of the first perception sensor and the second perception sensor, the confidence that the object is detected, and an object position indicated by the detected signal, whether the object is detected based on a preset decision-making method;
recording a duration in which the object is detected; and
controlling, in response to determining that the object is detected and the duration being greater than a time threshold, the optical module assembly to reduce a light intensity of the emitted projection light.

In some embodiments, at least one of the first perception sensor and the second perception sensor includes a single-point TOF sensor; determining, based on the signal detected by the at least one of the first perception sensor and the second perception sensor, the confidence that the at least one of the first perception sensor and the second perception sensor detects the object, includes:
setting the confidence of the single-point TOF sensor to 100% based on the signal detected by the single-point TOF sensor.

In some embodiments, at least one of the first perception sensor and the second perception sensor includes a multi-point TOF sensor; determining, based on the signal detected by the at least one of the first perception sensor and the second perception sensor, the confidence that the at least one of the first perception sensor and the second perception sensor detects the object, includes:
calculating the confidence that the multi-point TOF sensor detects the object according to a number of points, dispersion, and enclosing area of a point cloud formed by the signal detected by the multi-point TOF sensor.

In some embodiments, at least one of the first perception sensor and the second perception sensor includes an image acquisition unit; determining, based on the signal detected by the at least one of the first perception sensor and the second perception sensor, the confidence that the at least one of the first perception sensor and the second perception sensor detects the object, includes:
determining a size of a non-projection picture and a difference between images according to the signal detected by the image acquisition unit; and
calculating the confidence that the image acquisition unit detects the object based on the size of the non-projection picture and the difference between the images.

In some embodiments, determining whether the object is detected based on the preset decision-making method, includes:
determining a first weight value of a confidence that the first perception sensor detects the object;
determining a second weight value of a confidence that the second perception sensor detects the object;
determining a total confidence that the object is detected based on the first weight value and the second weight value; and
determining, based on the total confidence, whether the object is detected.

In some embodiments, the first area is tangent to or overlaps the second area.

In some embodiments, the projection device further includes an ambient light sensor disposed adjacent to the light outlet, and the ambient light sensor detects brightness and/or color of ambient light. The method further includes:
adjusting an intensity of at least one color in the projection light emitted by the optical module assembly according to the brightness and/or the color of the ambient light detected by the ambient light sensor, thereby adjusting a color temperature and/or white balance of a projected picture.

In some embodiments, the method further includes:
enabling the projection device to give a warning sound or display prompt information on a projected picture in response to at least one of the first perception sensor and the second perception sensor detecting that the object appears in front of the light outlet.

In some embodiments, the first perception sensor and the second perception sensor are disposed adjacent to the light outlet.

In some embodiments, the first perception sensor and the second perception sensor are disposed on left and right sides of the light outlet, respectively.

According to a seventh aspect of the embodiments of the present disclosure, a projection device is provided. The projection device includes:
an optical module assembly, where the optical module assembly includes a light outlet for emitting projection light;
a first perception sensor, where the first perception sensor is configured to detect whether an object appears in a first area in front of the light outlet;
a second perception sensor, where the second perception sensor is configured to detect whether an object appears in a second area in front of the light outlet, where the first area is different from the second area; and
at least one processor, where the at least one processor is configured to execute instructions to perform the method according to the sixth aspect.

According to an eighth aspect of the embodiments of the present disclosure, a projection device is provided. The projection device includes:
a housing, where the housing includes an air inlet and an air outlet, and the air inlet and the air outlet are formed in opposite sides of the housing;
an optical module assembly, where the optical module assembly is disposed in the housing and located on a straight line between the air inlet and the air outlet; and
a fan, where the fan is disposed between the air inlet and the air outlet and configured such that a generated airflow flows through the housing in a direction of the straight line between the air inlet and the air outlet.

In some embodiments, the projection device further includes:
a heat sink, where the heat sink is thermally coupled to the optical module assembly and includes heat dissipation fins,
where the airflow generated by the fan flows through the heat dissipation fins.

In some embodiments, the projection device further includes:
a first sealing member, where the first sealing member is disposed at a gap between the fan and the heat sink, such that a closed airflow flow channel is formed between the fan and the heat sink; and/or
a second sealing member, where the second sealing member is disposed between the heat dissipation fins and the air outlet, such that a closed airflow channel is formed between the heat dissipation fins and the air outlet.

In some embodiments, the sealing member includes a sealing tape.

In some embodiments, the optical module assembly includes at least two sets of light sources; the projection device further includes at least one heat pipe, the at least one heat pipe connecting at least one of the at least two sets of light sources to the heat sink to transfer heat from the at least one set of light sources to the heat sink.

It should be understood that what is described in this section is not intended to identify key or critical features of the embodiments of the present disclosure, and it is also not intended to limit the scope of the present disclosure. Other features of the present disclosure will become apparent from the following description.

### BRIEF DESCRIPTION OF THE DRAWINGS

In the accompanying drawings, unless otherwise specified, the same reference numerals across multiple accompanying drawings indicate the same or similar components or elements. The accompanying drawings are not necessarily drawn to scale. It should be understood that the accompanying drawings depict only some embodiments of the present disclosure and are therefore not to be considered as limiting of the scope of the present disclosure.
FIG. 1 shows a view of an entire projection device according to the embodiments of the present disclosure;
FIG. 2 shows an exploded view of mounting an optical module assembly provided with a first structure onto a lower housing according to the embodiments of the present disclosure;
FIG. 3 shows a top view of mounting an optical module assembly provided with a first structure onto a lower housing according to the embodiments of the present disclosure;
FIG. 4 shows an exploded view of mounting an optical module assembly provided with a second structure onto a lower housing according to the embodiments of the present disclosure;
FIG. 5 shows a top view of mounting an optical module assembly provided with a second structure onto a lower housing according to the embodiments of the present disclosure;
FIG. 6 shows a flowchart of a method for manufacturing a lower housing for a projection device according to the embodiments of the present disclosure;
FIG. 7 shows an exploded side view of mounting a speaker module and an optical module assembly according to the embodiments of the present disclosure;
FIG. 8 shows a side view of a speaker module and an optical module assembly in an assembled state according to the embodiments of the present disclosure;
FIG. 9 shows a perspective view of a double-sided speaker module according to the embodiments of the present disclosure;
FIG. 10 shows an exploded view of a single-sided speaker module according to the embodiments of the present disclosure;
FIG. 11 shows a partial top view of a projection device, including a light outlet of an optical module assembly, according to the embodiments of the present disclosure;
FIG. 12 shows a partial enlarged view at reference A in FIG. 11;
FIG. 13 shows a flowchart of a method for a projection device according to the embodiments of the present disclosure;
FIG. 14 shows perceptible ranges of a first perception sensor and a second perception sensor according to the embodiments of the present disclosure;
FIG. 15 shows a flowchart of a method for determining an adjustment of projection of an optical module assembly according to the embodiments of the present disclosure;
FIG. 16 shows a top view of a heat dissipation system of a projection device according to the embodiments of the present disclosure;
FIG. 17 shows a partial enlarged view at reference B in FIG. 16; and
FIG. 18 shows a perspective view of a heat sink according to the embodiments of the present disclosure.

### DETAILED DESCRIPTION

The following description is provided with reference to the accompanying drawings to explain exemplary embodiments of the present disclosure, including various details of the embodiments of the present disclosure to aid in understanding. These descriptions should be construed as exemplary only. Accordingly, it will be appreciated by those of ordinary skills in the art that various changes and modifications may be made to the embodiments described herein without departing from the scope of the present disclosure. Similarly, for clarity and conciseness, the descriptions below omit explanations of well-known functions and structures.

In the present disclosure, unless otherwise specified, the terms "first", "second", etc., are used for describing various elements and are not intended to define a positional relationship, a temporal relationship, or an importance relationship of these elements, and such terms are used only for distinguishing one element from another. In some examples, a first element and a second element may refer to the same instance of the element, while in some cases they may refer to different instances based on the context of the description.

The terms used in the description of the various described examples in the present disclosure are for the purpose of describing particular examples only and are not intended to be limiting. Unless otherwise clearly indicated in the context, if the number of elements is not specifically limited, there may be one or a plurality of elements. Further, the term "and/or" used herein encompasses any one of and all possible combinations of the listed items. The term "based on" should be construed as "based, at least in part, on".

### Solution for housing to be compatible with a plurality of models of optical module assemblies

The projection device includes an optical module assembly for projecting an image and a housing for mounting the optical module assembly. A plurality of models of optical module assemblies are provided according to different projection requirements or production requirements. Different models of optical module assemblies are provided with different structures, especially with different external mounting interfaces. In the related art, the housing of a projection device can only adapt to an optical module assembly of a specific model, but cannot be compatible with optical module assemblies of other models. This results in the need to produce a variety of corresponding housings, or a large number of components need to be replaced during production or maintenance to adapt the housing to other models of optical module assemblies.

In view of the above problems, the embodiments of the present disclosure provide a housing for a projection device. The housing according to the embodiments of the present disclosure includes: a main body structure and an optical module fixing structure. The main body structure defines the outer shape of the projection device, and for optical module assemblies provided with different structures (or referred to as different models), the main body structure is the same. The optical module fixing structure includes at least one optical module fastening component to mount the optical module assembly onto the housing, and the at least one optical module fastening component has different positions and/or dimensions on the optical module fixing structure according to the optical module assemblies of different structures, such that the housing can be suitable for mounting the optical module assemblies of different structures.

It can be seen that for optical module assemblies provided with different structures, the housing according to the embodiments of the present disclosure has different designs only at the optical module fixing structure. Therefore, in the present disclosure, the housing with the same appearance can be compatible with optical module assemblies of different models through minor modifications to components.

The housing according to the embodiments of the present disclosure may be formed by injection molding with a mold. The mold includes a mold main body and a set of mold inserts capable of being embedded into the mold main body. The main body structure of the housing is injection molded by using the mold main body. For optical module assemblies provided with different structures, the main body structures may be injection molded by using the same mold main body. The optical module fixing structure of the housing includes at least one optical module fastening component to mount at least a part of the optical module assembly onto the housing, and the optical module fixing structure is injection molded by using the mold insert. For optical module assemblies provided with different structures, the optical module fixing structure is injection molded by using different mold inserts of the set of mold inserts, such that the at least one optical module fastening component that is injection molded has different positions and/or dimensions on the optical module fixing structure according to the optical module assemblies of different structures, thereby being suitable for mounting the optical module assemblies of different structures onto the housing.

It can be seen that by splitting the mold insert from the mold, when different mold inserts are switched, the optical module fastening component (for example, a threaded hole for a screw to be screwed in) on the optical module fixing structure of the housing may have different positions and/or dimensions, such that housings with the same appearance can be compatible with optical module assemblies of different models. In this solution, optical module assemblies of different models are assembled on housings with the same appearance at a relatively low cost.

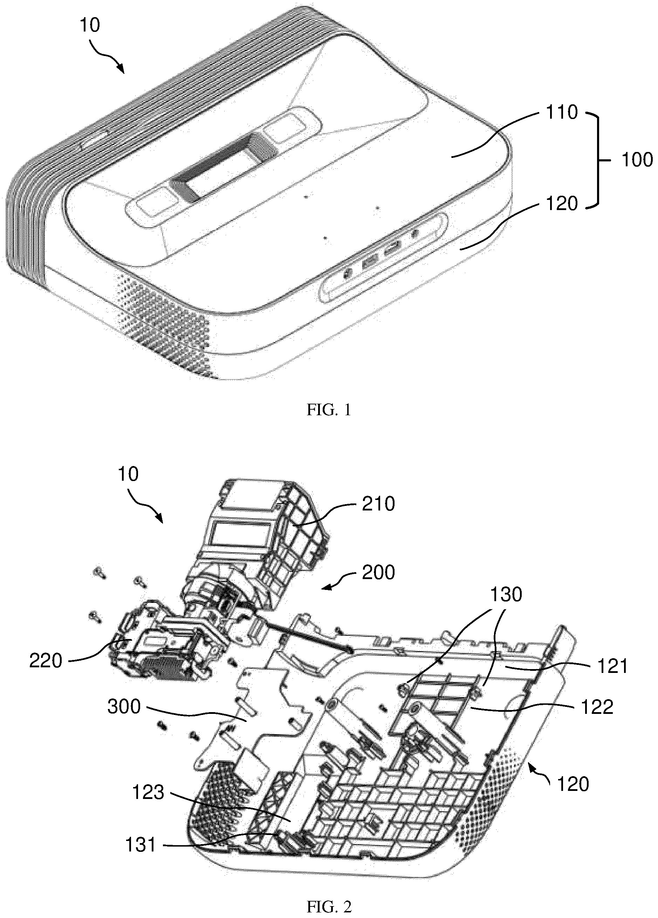

The embodiments of the present disclosure will be described in detail below with reference to FIG. 1 to FIG. 6.

FIG. 1 shows a projection device 10 according to the embodiments of the present disclosure. The projection device 10 includes a housing 100, and the housing 100 includes an upper housing 110 and a lower housing 120 assembled together.

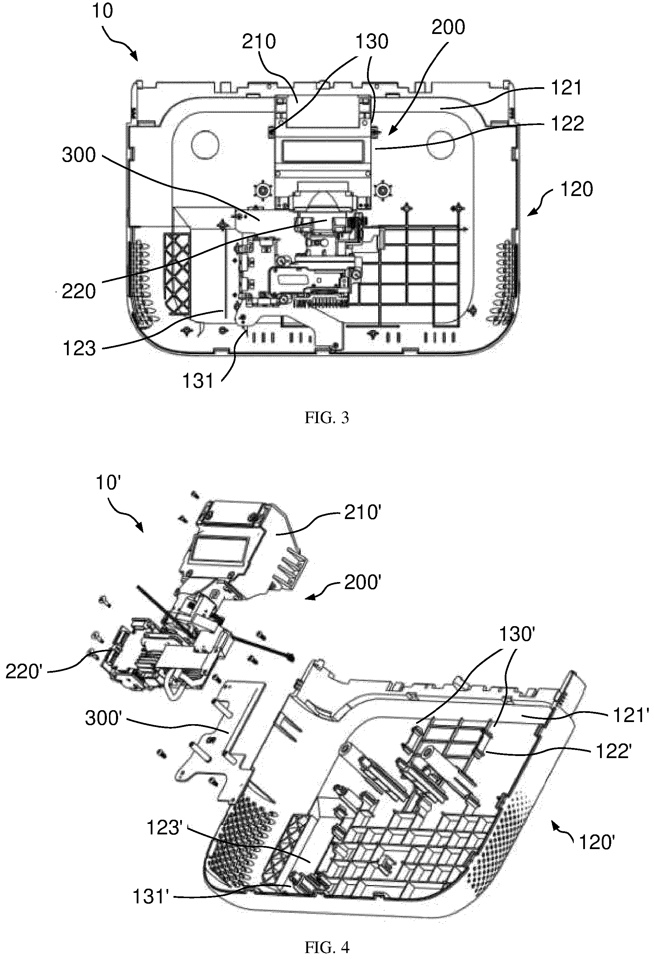

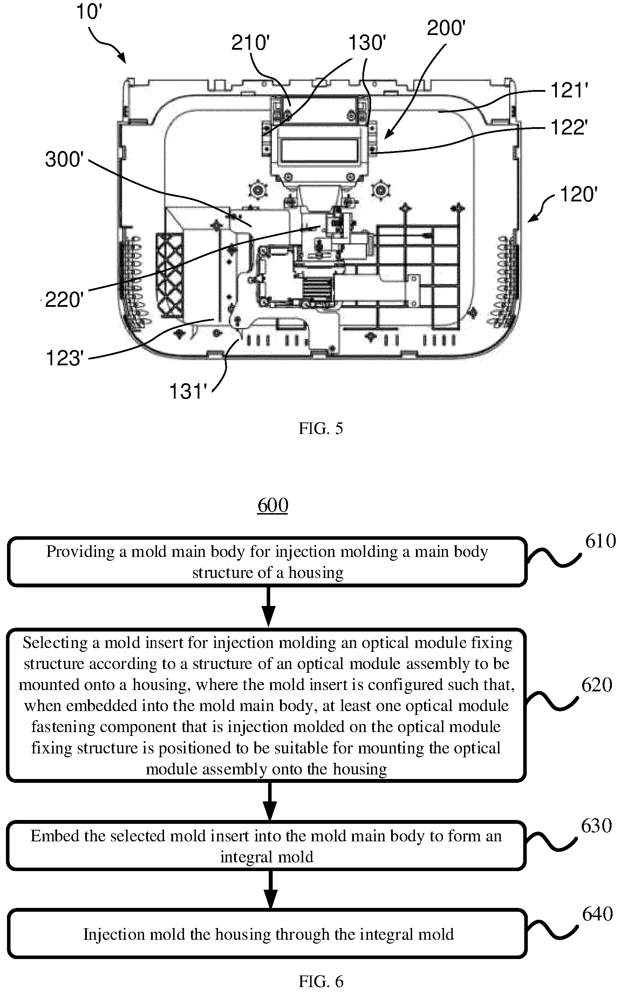

FIG. 2 and FIG. 3 show an internal structure of the projection device 10 after the upper housing 110 is removed. As shown in FIG. 2 and FIG. 3, the projection device 10 further includes an optical module assembly 200, and the optical module assembly 200 is mounted on the lower housing 120. The optical module assembly 200 is provided with a first structure. A plurality of models of optical module assemblies may be provided according to different projection requirements. Different models of optical module assemblies are provided with different structures. FIG. 4 and FIG. 5 show an optical module assembly 200' provided with a second structure and a lower housing 120' for mounting the optical module assembly 200'. The second structure is different from the first structure.

First, referring to FIG. 2 and FIG. 3, the optical module assembly 200 provided with the first structure includes a lens portion 210 and a light source portion 220 opposite to the lens portion. In some embodiments, to mount the optical module assembly 200 onto the lower housing 120, the projection device further includes an optical module support 300. The lens portion 210 of the optical module assembly 200 may be directly mounted onto the lower housing 120, while the light source portion 220 of the optical module assembly 200 needs to be mounted onto the lower housing 120 through the optical module support 300. The light source portion 220 of the optical module assembly 200 may be first mounted onto the optical module support 300 and then mounted onto the lower housing 120 via the optical module support 300. In addition, the optical module support 300 may also be first mounted onto the lower housing 120, and the light source portion 220 of the optical module assembly 200 is then mounted onto the optical module support 300. The lower housing 120 for mounting the optical module assembly 200 includes a main body structure 121, an optical module fixing structure 122, and an optical module support fixing structure 123.

The main body structure 121 of the lower housing 120 defines the outer shape of the projection device. The optical module fixing structure 122 of the lower housing 120 includes at least one optical module fastening component 130 for mounting the optical module assembly 200 onto the lower housing. The optical module support fixing structure 123 includes at least one optical module support fastening component 131 for mounting the optical module support 300 onto the lower housing.

Before the optical module assembly 200 is mounted onto the lower housing 120, the optical module support 300 is first mounted onto the light source portion 220 of the optical module assembly 200. Then, the lens portion 210 of the optical module assembly 200 is mounted onto the lower housing 120 through the at least one optical module fastening component 130, and at the same time, the optical module support 300 is mounted onto the lower housing 120 through the at least one optical module support fastening component 131, such that the light source portion 220 of the optical module assembly 200 is mounted onto the lower housing 120. In some embodiments, the optical module support 300 may also be first mounted onto the lower housing 120 through the at least one optical module support fastening component 131, the light source portion 220 of the optical module assembly 200 is then mounted onto the optical module support 300, and at the same time, the lens portion 210 of the optical module assembly 200 is mounted onto the lower housing 120 through the at least one optical module fastening component 130. The position and/or the dimension of the at least one optical module fastening component 130 on the optical module fixing structure 122 of the lower housing 120 matches the position and/or the dimension of a mounting component on the lens portion 210 of the optical module assembly 200. The position and/or the dimension of the at least one optical module support fastening component 131 on the optical module support fixing structure 123 is configured to be suitable for mounting the optical module support 300 onto the lower housing, and the position and/or the dimension of at least one mounting position on the optical module support 300 matches the position and/or the dimension of a mounting component on the light source portion 220 of the optical module assembly 200, thereby being suitable for separately mounting the lens portion 210 and the light source portion 220 that form the optical module assembly 200 onto the lower housing 120.

In some embodiments, the at least one optical module fastening component 130 is a threaded hole. The optical module assembly 200 may be fastened to the lower housing 120 by screwing a screw into the threaded hole. In some embodiments, the at least one optical module support fastening component 131 may also be a threaded hole. The optical module support 300 may be fastened to the lower housing 120 by screwing a screw into the threaded hole. It should be understood that the at least one optical module fastening component 130 and the at least one optical module support fastening component 131 may be any type of fastening apparatus, including but not limited to a threaded hole, an engaging member, and the like.

FIG. 4 and FIG. 5 show an optical module assembly 200' provided with a second structure and a lower housing 120' for mounting the optical module assembly 200'. The second structure is different from the first structure. The lower housing 120' for mounting the optical module assembly 200' includes a main body structure 121', an optical module fixing structure 122', and an optical module support fixing structure 123'. To mount the optical module assembly 200' onto the lower housing 120', the projection device further includes an optical module support 300'.

The main body structure 121' of the lower housing 120' defines the outer shape of the projection device. The optical module fixing structure 122' of the lower housing 120' includes at least one optical module fastening component 130' for mounting the optical module assembly 200' onto the lower housing. The optical module support fixing structure 123' includes at least one optical module support fastening component 131' for mounting the optical module support 300' onto the lower housing.

Before the optical module assembly 200' is mounted onto the lower housing 120', the optical module support 300' is first mounted onto a light source portion 220' of the optical module assembly 200'. Then, the lens portion 210' of the optical module assembly 200' is mounted onto the lower housing 120' through the at least one optical module fastening component 130', and at the same time, the optical module support 300' is mounted onto the lower housing 120' through the at least one optical module support fastening component 131', such that the light source portion 220' of the optical module assembly 200' is mounted onto the lower housing 120'. In some embodiments, the optical module support 300' may also be first mounted onto the lower housing 120' through the at least one optical module support fastening component 131', the light source portion 220' of the optical module assembly 200' is then mounted onto the optical module support 300', and at the same time, the lens portion 210' of the optical module assembly 200' is mounted onto the lower housing 120' through the at least one optical module fastening component 130'. The position and/or the dimension of the at least one optical module fastening component 130' on the optical module fixing structure 122' of the lower housing 120' matches the position and/or the dimension of a mounting component on the lens portion 210' of the optical module assembly 200'. The position and/or the dimension of the at least one optical module support fastening component 131' on the optical module support fixing structure 123' is configured to be suitable for mounting the optical module support 300' onto the lower housing, and the position and/or the dimension of at least one mounting position on the optical module support 300' matches the position and/or the dimension of a mounting component on the light source portion 220' of the optical module assembly 200', thereby being suitable for separately mounting the lens portion 210' and the light source portion 220' that form the optical module assembly 200' onto the lower housing 120'. Compared with the lower housing 120 for mounting the optical module assembly 200 provided with the first structure shown in FIG. 2 and FIG. 3, the lower housing 120' for mounting the optical module assembly 200' provided with the different second structure shown in FIG. 4 and FIG. 5 differs from the lower housing 120 at the optical module fixing structure 122', and the remaining parts are consistent with those of the lower housing 120. For the lower housings, the main body structure of the lower housings is kept consistent, such that housings with the same appearance can be compatible with optical module assemblies of different types. The optical module assembly 200 provided with the first structure and the optical module assembly 200' provided with the different second structure respectively cooperate with the corresponding optical module support 300 and optical module support 300', such that the same optical module support fixing structure can be used. That is, the connection positions and connection methods between various optical module supports and the lower housing are the same, while the connection positions and/or connection methods between various optical module supports and the light source portion of the optical module assembly of the corresponding structure are different. The lower housing has different designs only at the optical module fixing structure. Therefore, in the present disclosure, the housing with the same appearance can be compatible with optical module assemblies of different models through minor modifications to components.

In some embodiments, the housing according to the embodiments of the present disclosure may be formed by injection molding with a mold. FIG. 6 shows a method 600 for manufacturing a lower housing for a projection device according to the embodiments of the present disclosure. The method 600 uses injection molding with a mold to manufacture the housing. The mold includes a mold main body and a set of mold inserts capable of being embedded into the mold main body.

As shown in FIG. 6, in step 610, a mold main body for injection molding the main body structure of the housing is provided. In step 620, a mold insert for injection molding the optical module fixing structure is selected according to the structure of the optical module assembly to be mounted onto the housing, where the mold insert is configured such that, when embedded into the mold main body, the position and/or the dimension of at least one optical module fastening component that is injection molded on the optical module fixing structure is configured to be suitable for mounting the optical module assembly onto the housing. In step 630, the selected mold insert is embedded into the mold main body to form an integral mold. Moreover, in step 640, the housing is injection molded through the integral mold.

For optical module assemblies of different models, for example, an optical module assembly provided with a first structure and an optical module assembly provided with a different second structure, step 610 may further include: for the optical module assembly provided with the first structure or the second structure, providing the same mold main body for injection molding the main body structure of the housing. Step 620 may further include: selecting a first mold insert according to the optical module assembly provided with the first structure, where the first mold insert is configured such that, when embedded into the mold main body, the position and/or the dimension of the at least one optical module fastening component that is injection molded on the optical module fixing structure is configured to be suitable for mounting the optical module assembly provided with the first structure onto the housing; or selecting a second mold insert according to the optical module assembly provided with the second structure, where the second mold insert is configured such that, when embedded into the mold main body, the position and/or the dimension of the at least one optical module fastening component after injection molding on the optical module fixing structure is configured to be suitable for mounting the optical module assembly provided with the second structure onto the housing.

According to the manufacturing method 600 of the embodiments of the present disclosure, by splitting the mold insert from the mold, when different mold inserts are switched, the optical module fastening component on the optical module fixing structure of the housing may have different positions and/or shapes and/or dimensions. According to the method, housings of the same appearance that are compatible with optical module assemblies of different models are manufactured at a relatively low cost.

### Solution to alleviate impact of vibration of speaker module on optical module assembly

The projection device usually further has an audio playback function, and therefore is provided with a speaker module mounted in the housing. However, vibration generated during the operation of the speaker module is transmitted to the optical module assembly, causing the projected image to shake, thereby significantly affecting the projection effect.

In view of the above problems, the embodiments of the present disclosure provide an improved projection device. According to the projection device of the embodiments of the present disclosure, the optical module assembly and the speaker module are respectively mounted onto the lower housing and the upper housing, such that the path for the vibration of the speaker module to be transmitted to the optical module assembly is extended, thereby consuming vibration energy to reduce impact on the optical module assembly.

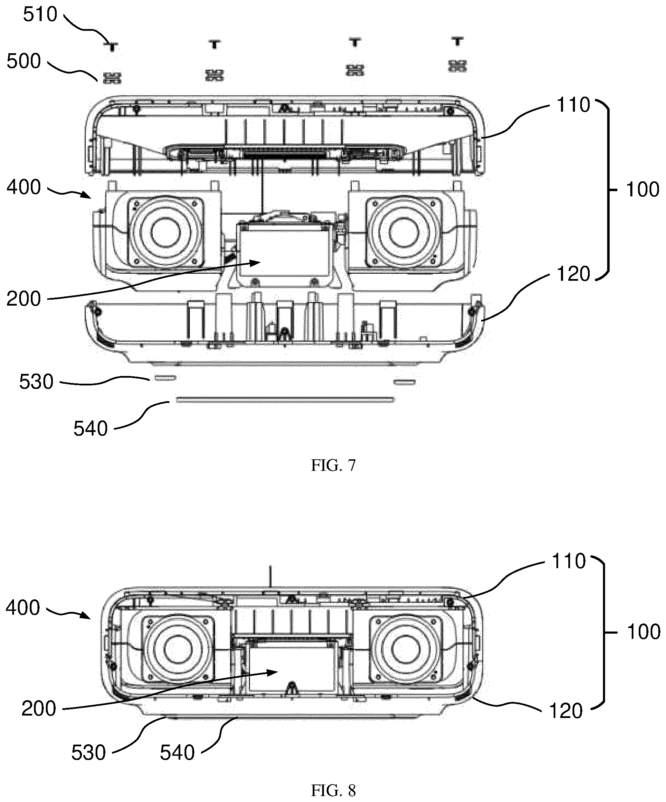

The embodiments of the present disclosure will be described in detail below with reference to FIG. 7 to FIG. 10.

FIG. 7 shows an exploded side view of mounting a speaker module and an optical module assembly according to the embodiments of the present disclosure. FIG. 8 shows a side view of a speaker module and an optical module assembly in an assembled state according to the embodiments of the present disclosure.

Referring to FIG. 7 and FIG. 8, the projection device includes: a housing assembly 100, where the housing assembly 100 includes an upper housing 110 and a lower housing 120, and the upper housing 110 and the lower housing 120 are detachably connected together; an optical module assembly 200, where the optical module assembly 200 is mounted onto the lower housing 120 and separated from the upper housing 110; and a speaker module 400, where the speaker module 400 is mounted onto the upper housing 110 and separated from the lower housing 120. The optical module assembly 200 is mounted onto the lower housing 120 and the speaker module 400 is mounted onto the upper housing 110. The two are separately mounted, instead of being mounted onto the upper housing or the lower housing at the same time. Therefore, the path for the vibration of the speaker module to be transmitted to the optical module assembly is extended, thereby consuming vibration energy to reduce impact on the optical module assembly.

In some embodiments, the upper housing 110 is further provided with a speaker buffer pad 500 and a fastener 510, and the fastener 510 mounts the speaker module 400 onto the upper housing 110 via the speaker buffer pad 500, such that the speaker module 400 is spaced apart from the upper housing 110 by the speaker buffer pad 500. The speaker module 400 is thus disposed in the housing 100 in a floating manner. This floating manner can effectively reduce the impact of the vibration of the speaker module on the upper housing, thereby reducing the impact on the lower housing connected to the upper housing, and also has an excellent playing sound effect.

In some embodiments, the outer surface of the lower housing 110 is further provided with a first housing buffer pad 530 and a second housing buffer pad 540. The first housing buffer pad 530 and the second housing buffer pad 540 mainly function to prevent displacement of the entire device and to provide buffering and shock absorption.

In some embodiments, an elastic sealing member is further disposed between the upper housing 110 and the lower housing 120. The elastic sealing member is disposed on an engaging surface between the upper housing 110 and the lower housing 120. This not only plays a sealing role, but also can buffer the vibration between the upper housing 110 and the lower housing 120, thereby further reducing the impact of the vibration of the speaker module on the optical module assembly.

In some embodiments, the optical module assembly 200 is further provided with a counterweight. The counterweight is usually disposed on a lens portion of the optical module assembly 200. The counterweight can reduce the vibration amplitude and/or frequency of the optical module assembly, thereby effectively alleviating the problem of an abnormal shake of the projected picture during audio playback.

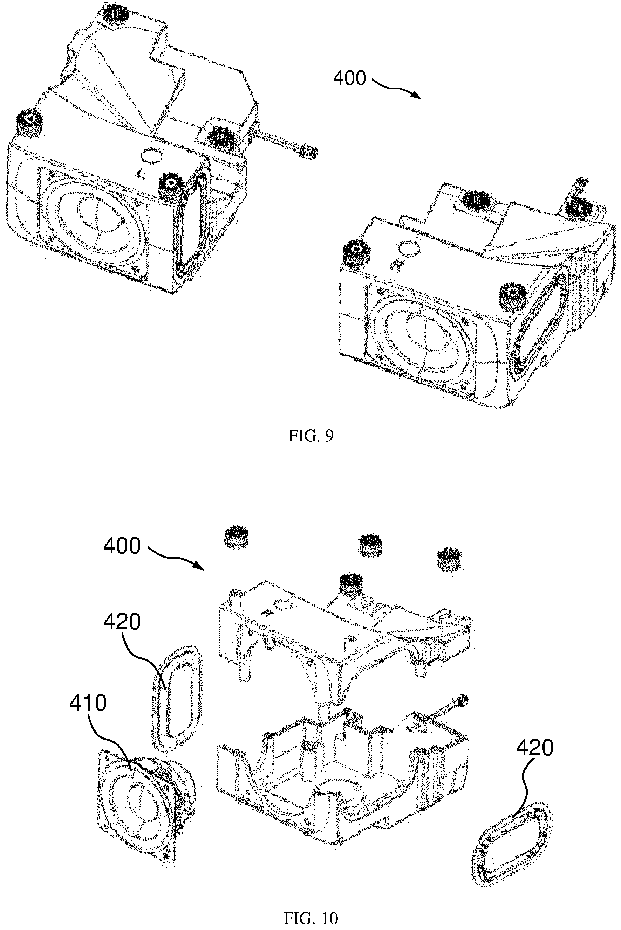

FIG. 9 and FIG. 10 further show a speaker module according to the embodiments of the present disclosure. FIG. 9 shows a perspective view of a double-sided speaker module 400 according to the embodiments of the present disclosure. FIG. 10 further shows a single-sided speaker module 400 in an exploded view. The single-sided speaker module 400 includes a speaker main body 410 and two passive low-frequency radiators 420 disposed on the left and right sides of the speaker main body 410, respectively.

### Anti-direct-viewing solution

To protect human eyes, the projection device needs to have an anti-direct-viewing function. However, in the related art, the anti-direct-viewing function has a small detection range and a poor anti-direct-viewing effect, and the existing sensor cannot be reused, resulting in problems such as high costs and waste of resources. Therefore, an improved anti-direct-viewing solution is needed, which can accurately, quickly, and reliably determine whether there is a risk of direct viewing by human eyes, and immediately reduce the brightness of the optical module or even turn off the optical module.

In view of the above problems, the embodiments of the present disclosure provide an improved method for a projection device and a projection device. According to the method for a projection device and the projection device, a first perception sensor and a second perception sensor are used to separately detect whether an object appears in different areas, thereby achieving a larger detection range and a more reliable anti-direct-viewing detection effect. Moreover, at least one of the first perception sensor and the second perception sensor uses a sensor provided in the projection device for other purposes, for example, reusing a multi-point time-of-flight sensor on the projection device for measuring a projection surface, i.e., a multi-point TOF (time-of-flight) sensor. The existing sensor is reused, such that the number of sensors on the device body is reduced, and the cost is reduced while achieving an effective anti-direct-viewing effect.

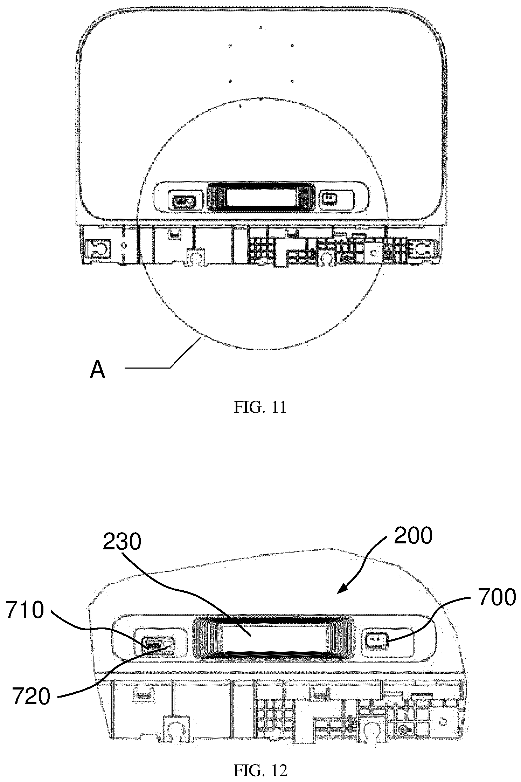

The embodiments of the present disclosure will be described in detail below with reference to FIG. 11 to FIG. 15.

FIG. 11 shows a top view of a projection device 10 according to the embodiments of the present disclosure. FIG. 12 shows a partial enlarged view at reference A in FIG. 11. As shown in FIG. 11 and FIG. 12, the projection device 10 includes: an optical module assembly 200, where the optical module assembly 200 includes a light outlet 230 for emitting projection light; and a first perception sensor 700 and a second perception sensor 710.

It should be understood that the positions of the first perception sensor 700 and the second perception sensor 710 on the projection device shown in FIG. 11 are merely examples, and the first perception sensor 700 and the second perception sensor 710 may be disposed at any appropriate position as required. In addition, any suitable sensor type may be selected for the first perception sensor 700 and the second perception sensor 710 in the case of meeting functional requirements. In some embodiments, any one of the first perception sensor and the second perception sensor is one of an image acquisition unit, a single-point TOF sensor, a multi-point TOF sensor, and a passive infrared PIR sensor.

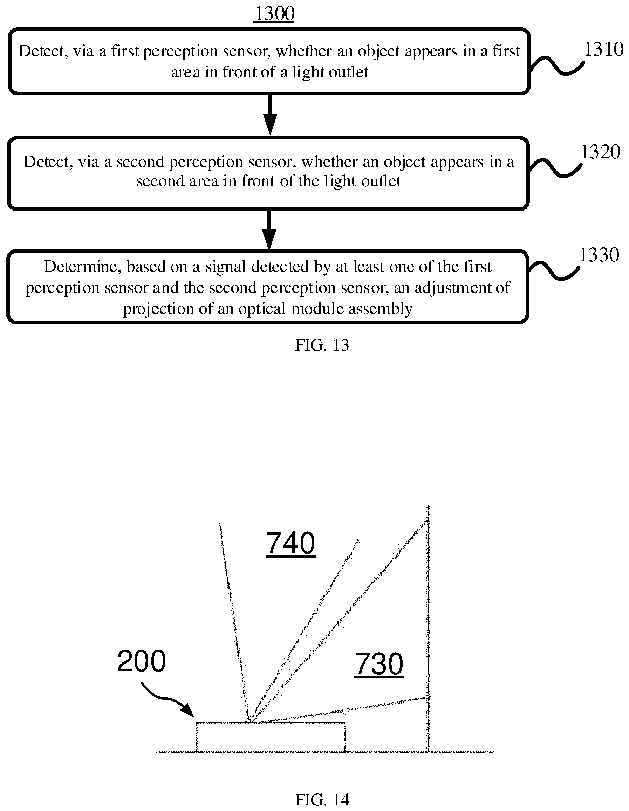

FIG. 13 shows a method 1300 for a projection device according to the embodiments of the present disclosure. In step 1310, whether an object appears in a first area in front of the light outlet is detected via the first perception sensor. In step 1320, whether an object appears in a second area in front of the light outlet is detected via the second perception sensor, where the first area is different from the second area. In step 1330, an adjustment of the projection of the optical module assembly is determined based on a signal detected by at least one of the first perception sensor and the second perception sensor.

In the embodiment as shown in FIG. 14, the first perception sensor may use a multi-point TOF sensor. The perceptible range 730 of the first perception sensor may cover the projection area in front. The second perception sensor may use a single-point TOF or PIR sensor. The perceptible range 740 of the second perception sensor may cover an area above the device body that needs an anti-direct-viewing function, and the area above the device body is proximal to the light outlet 230. Preferably, the perceptible range 730 of the first perception sensor is tangent to or overlaps the perceptible range 740 of the second perception sensor, such that an anti-direct-viewing effect without blind angles can be achieved.

In addition, the method 1300 according to the embodiments of the present disclosure can also achieve the reuse of sensors, thereby reducing the number of sensors and reducing the cost while achieving an effective anti-direct-viewing effect. For example, a multi-point TOF sensor is usually configured to obtain a distance between a light outlet of an optical module of a projection device and a projection surface, and adjust a lens unit of the optical module based on the distance to obtain a clear projection picture; and/or detect the spatial position of the projection surface through the multi-point TOF to determine the attitude angle and/or the position of the projection device relative to the projection surface, and then perform trapezoidal correction on the projected picture according to the relative attitude angle and/or the relative position to obtain a rectangular projected picture that meets a preset length-to-width ratio requirement. In actual use, the primary purpose of the multi-point TOF is to detect relevant parameters of the projection surface, so the detection angle thereof is different from that of the single-point TOF. In the method 1300, the multi-point TOF sensor is further used to detect whether the object appears in front of the light outlet, thereby achieving the reuse of the multi-point TOF sensor.

In step 1330, determining the adjustment of the projection of the optical module assembly, includes determining whether an obstacle exists in front of the sensor. It should be noted that when different sensors are used, methods for determining whether an obstacle exists in front of the sensors are different.

Determining, based on a signal detected by the single-point TOF sensor, the adjustment of the projection of the optical module assembly, includes: determining, in response to the detected signal being less than a threshold, that the object is detected, where the detected signal is a distance between the single-point TOF sensor and the object; and controlling, in response to detecting the object, the optical module assembly to reduce the light intensity of the emitted projection light or turning off the optical module assembly.

Determining, based on a signal detected by the multi-point TOF sensor, the adjustment of the projection of the optical module assembly, includes: fitting a plane based on a point cloud formed by the detected signal; calculating a distance from the point cloud to the fitted plane; determining, in response to the distance being greater than a threshold, that the object is detected; and controlling, in response to detecting the object, the optical module assembly to reduce the light intensity of emitted projection light or turning off the optical module assembly.

Determining, based on a signal detected by the image acquisition unit, the adjustment of the projection of the optical module assembly, includes: performing frame synchronization with a projection picture of the optical module through a timestamp; acquiring an image through the image acquisition unit and obtaining an optical module projection image at a corresponding time; determining, in response to a difference between the image acquired by the image acquisition unit and the optical module projection image at the corresponding time being greater than a threshold, that the object is detected; and controlling, in response to detecting the object, the optical module assembly to reduce the light intensity of the emitted projection light.

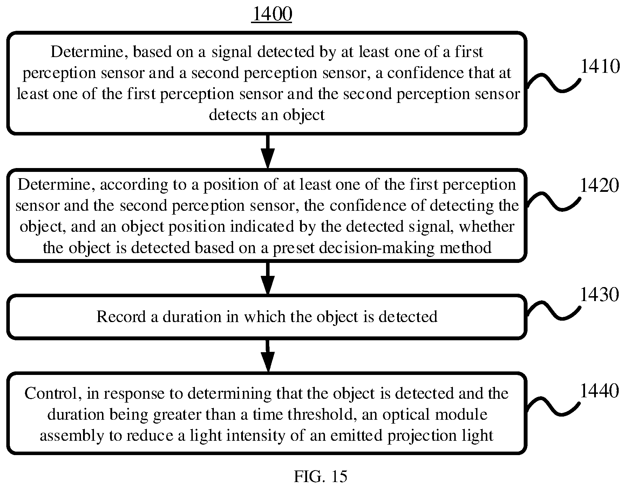

Further, in step 1330, to reliably determine whether there is a risk of direct viewing by human eyes and reduce the impact of an irrelevant signal detected by the sensor on determining whether to adjust the optical module assembly, a decision-making method 1400 shown in FIG. 15 is further included when determining the adjustment of the projection of the optical module assembly. In step 1410, a confidence that at least one of the first perception sensor and the second perception sensor detects the object is determined based on the signal detected by at least one of the first perception sensor and the second perception sensor. In step 1420, whether the object is detected is determined based on a preset decision-making method according to the position of at least one of the first perception sensor and the second perception sensor, the confidence that the object is detected, and an object position indicated by the detected signal. In step 1430, a duration in which the object is detected is recorded. Moreover, in step 1440, in response to determining that the object is detected and the duration being greater than a time threshold, the optical module assembly is controlled to reduce the light intensity of the emitted projection light or turn off the optical module assembly.

It should be noted that in step 1410, different methods are used to determine the confidence that the sensor detects an object according to the type of the sensor used.

If a single-point TOF sensor is used, since the sensor directly detects the distance to an obstacle, determining the confidence that the single-point TOF sensor detects the object includes: setting the confidence of the single-point TOF sensor to 100% based on the signal detected by the single-point TOF sensor.

If a multi-point TOF sensor is used, it is necessary to avoid identifying the projection picture as an obstacle. Therefore, determining the confidence that the multi-point TOF sensor detects the object includes: calculating the confidence that the multi-point TOF sensor detects the object according to the number of points, dispersion, and enclosing area of the point cloud formed by the signal detected by the multi-point TOF sensor.

If an image acquisition unit (such as a camera) is used, it is also necessary to avoid identifying the projection picture as an obstacle. Therefore, determining the confidence that the image acquisition unit detects the object includes: determining the size of the non-projection picture and a difference between the images according to the signal detected by the image acquisition unit; and calculating the confidence that the image acquisition unit detects the object based on the size of the non-projection picture and the difference between the images.

In addition, it should be understood that for each sensor, the sliding window size and the trigger threshold are set according to the sensor feature (frame rate, data error rate, or the like), and a plurality of frames of data are filtered to determine whether to trigger the obstacle detection of the sensor.

When two sensors are used to jointly determine whether to adjust the optical module assembly, the weights of detection results of the two sensors also need to be determined, so as to make a fusion decision on whether the obstacle is sensed. Therefore, in step 1420, determining whether the object is detected based on the preset decision-making method includes: determining a first weight value of a confidence that the first perception sensor detects the object; determining a second weight value of a confidence that the second perception sensor detects the object; determining a total confidence that the object is detected based on the first weight value and the second weight value; and determining, based on the total confidence, whether the object is detected.

In some embodiments, the projection device further includes an ambient light sensor 720 disposed proximal to the light outlet 230. The ambient light sensor 720 can detect the brightness and/or color of the ambient light and accordingly adjust the light-emitting intensity of the light source of each color of the optical module, thereby adjusting the color temperature and/or white balance of the projection picture.

In some embodiments, the method 1300 shown in FIG. 13 further includes enabling the projection device to give a warning sound or display prompt information on the projected picture in response to at least one of the single-point TOF sensor and the multi-point TOF sensor detecting that the object appears in front of the light outlet.

The embodiments of the present disclosure further provide a projection device. The projection device includes: an optical module assembly, where the optical module assembly includes a light outlet for emitting projection light; a first perception sensor, where the first perception sensor is configured to detect whether an object appears in a first area in front of the light outlet; a second perception sensor, where the second perception sensor is configured to detect whether an object appears in a second area in front of the light outlet, where the first area is different from the second area; and at least one processor, where the at least one processor is configured to execute instructions to perform the method according to the embodiments of the present disclosure.

### Heat dissipation solution

The projection device is often provided with a plurality of heat dissipation fans to reduce the temperature throughout the projection device. However, the arrangement of the plurality of fans results in many problems such as high costs and high noise. In addition, a complex heat dissipation structure affects the normal operation of the projection device. In actual use, the main heating elements of the projection device include a light source portion of the optical module, a circuit board, and the like. The light source portion generates the most heat, and the heat generation thereof accounts for the largest proportion in the entire projection device. Therefore, the heat dissipation effect of the light source portion, the circuit board, and the like greatly affects the operation of the projection device.

In view of the above problems, the embodiments of the present disclosure provide a projection device. According to the projection device, an air inlet and an air outlet are formed such that the light source portion of the optical module assembly and the fan are located on a straight line between the air inlet and the air outlet. Further, the circuit board may be placed parallel to the straight line, such that the cooling air directly blows through the light source portion of the optical module assembly and/or the circuit board, thereby improving the heat dissipation effect.

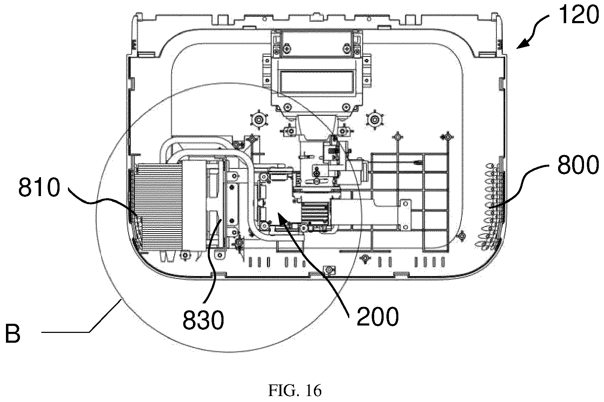

The embodiments of the present disclosure will be described in detail below with reference to FIG. 16 to FIG. 18.

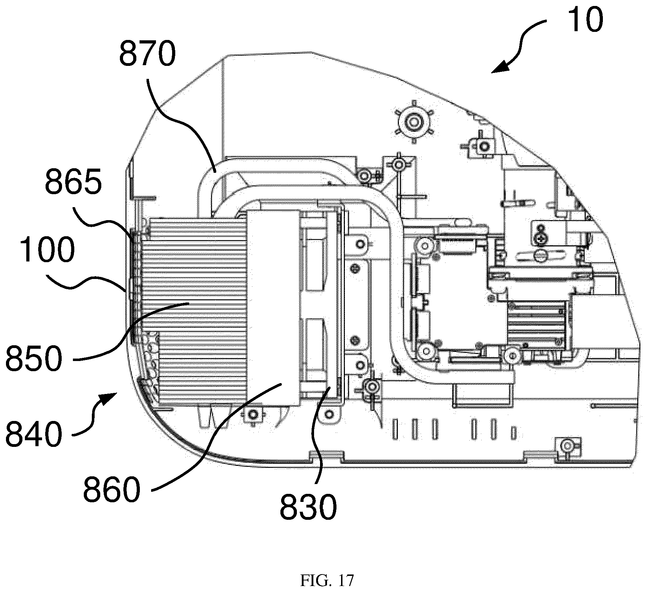

FIG. 16 shows a projection device provided with a heat dissipation system according to the embodiments of the present disclosure. FIG. 17 shows a partial enlarged view at reference B in FIG. 16. Referring to FIG. 16 and FIG. 17, the projection device 10 includes a housing 100, where the housing 100 includes an air inlet 800 and an air outlet 810, and the air inlet 800 and the air outlet 810 are formed in opposite sides of the housing 100; an optical module assembly 200, where the optical module assembly 200 is disposed in the housing 100, the optical module assembly includes a light source portion, and the light source portion is located on a straight line between the air inlet 800 and the air outlet 810; and a fan 830, where the fan 830 is disposed between the air inlet 800 and the air outlet 810 and configured such that a generated airflow flows through an inside of the housing 100 in a direction of the straight line between the air inlet 800 and the air outlet 810. By forming the air inlet and the air outlet in the left and right sides of the housing, respectively, the airflow direction of the fan is substantially coaxial with the air inlet and the air outlet correspondingly, thereby reducing the flow path of the airflow, such that the low-temperature air can quickly enter the housing and the high-temperature air is discharged. Further, the design of the airflow circulation path reduces the diffusion of the air heated by the heat source of the projection device inside the device and prevents other elements inside the projection device from being heated by the air.

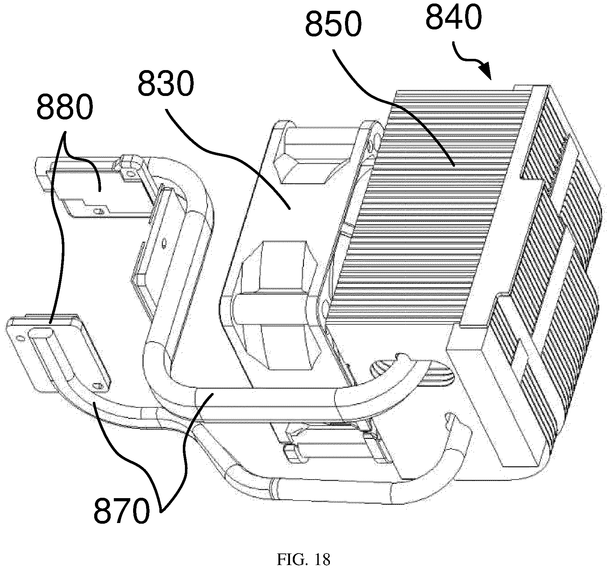

In some embodiments, the projection device 10 further includes a heat sink 840. FIG. 18 shows a perspective view of a heat sink according to the embodiments of the present disclosure. The heat sink 840 is thermally coupled to the optical module assembly 200 and includes heat dissipation fins 850. The airflow generated by the fan 830 flows through the heat dissipation fins 850 to take heat out of the housing.

In some embodiments, a first sealing member 860 is further included, and the first sealing member 860 is arranged at a gap between the fan 830 and the heat sink 840, such that a closed airflow flow channel is formed between the fan 830 and the heat sink 840, thereby enabling the high-temperature air to be quickly discharged out of the housing and improving the heat dissipation efficiency. In some embodiments, a second sealing member 865 is further included. The second sealing member 865 is disposed between the heat dissipation fins 850 and the air outlet 810, so as to directly discharge the high-temperature airflow flowing through the heat dissipation fins 850 through the air outlet 810 without flowing back into the housing. In some embodiments, the first sealing member 860 and/or the second sealing member 865 includes a sealing tape. The sealing tape is merely an example and may be any material that can achieve a sealing effect, for example, an adhesive strip or foam.

In some embodiments, the optical module assembly 200 includes at least two sets of light sources. The heat sink 840 may further include at least one heat pipe 870, and the end portions of the heat pipe 870 are connected to heat dissipation substrates 880, as shown in FIG. 18. Each heat dissipation substrate 880 is thermally coupled to at least one set of light sources and transfers heat from the light sources to the heat pipe 870. The at least one heat pipe 870 connects at least one of the at least two sets of light sources to the heat dissipation fins 850 to transfer heat from the at least one set of light sources to the heat dissipation fins 850.

While the embodiments or examples of the present disclosure have been described with reference to the accompanying drawings, it should be understood that the methods, systems, and devices described above are merely exemplary embodiments or examples. The scope of the present disclosure is not limited by these embodiments or examples, but rather is defined only by the claims as granted and equivalents thereof. Various elements in the embodiments or examples may be omitted or replaced by their equivalent elements. In addition, the steps may be performed in an order different from that described in the present disclosure. Further, the elements in the embodiments or examples may be combined in various ways. It is important to note that as technology evolves, many of the elements described herein may be replaced by equivalent elements that appear after the present disclosure.

## Claims

1. A housing for a projection device, wherein the projection device comprises an optical module assembly, the optical module assembly is provided with a first structure or a second structure, and the second structure is different from the first structure; and the housing comprises:
a main body structure, defining an outer shape of the projection device, wherein for the optical module assembly provided with the first structure or the second structure, the main body structure of the housing is the same; and
an optical module fixing structure, wherein the optical module fixing structure comprises at least one optical module fastening component, and a position and/or a dimension of the at least one optical module fastening component on the optical module fixing structure is configured to:
be suitable for mounting at least a part of the optical module assembly provided with the first structure onto the housing according to the optical module assembly provided with the first structure; or
be suitable for mounting at least a part of the optical module assembly provided with the second structure onto the housing according to the optical module assembly provided with the second structure.

2. The housing according to claim 1, wherein the projection device further comprises an optical module support, and the optical module support is configured to be suitable for mounting at least a part of the optical module assembly provided with the first structure or the second structure; and wherein the housing further comprises:
an optical module support fixing structure, wherein the optical module support fixing structure comprises at least one optical module support fastening component, and a position and/or a dimension of the at least one optical module support fastening component on the optical module support fixing structure is configured to be suitable for mounting the optical module support onto the housing.

3. The housing according to claim 2, wherein the optical module assembly comprises a lens portion and a light source portion opposite to the lens portion, wherein the at least one optical module fastening component is configured to mount the lens portion onto the optical module fixing structure, and wherein the light source portion is mounted onto the optical module support.

4. The housing according to claim 3, wherein the at least one optical module fastening component and/or the at least one optical module support fastening component comprises a threaded hole.

5. The housing according to any one of claims 1 to 4, wherein the housing is a lower housing of the projection device.

6. The housing according to any one of claims 1 to 4, wherein the housing is integrally formed by injection molding with a mold.

7. A housing for a projection device, wherein the projection device comprises an optical module assembly, the optical module assembly is provided with a first structure or a second structure, and the second structure is different from the first structure; and the housing is formed by injection molding with a mold, the mold comprises a mold main body and a set of mold inserts capable of being embedded into the mold main body, and the housing comprises:
a main body structure, defining an outer shape of the projection device and injection molded by using the mold main body, wherein for the optical module assembly provided with the first structure or the second structure, the main body structure is injection molded by using the same mold main body; and
an optical module fixing structure, wherein the optical module fixing structure comprises at least one optical module fastening component to mount at least a part of the optical module assembly onto the housing, and the optical module fixing structure is injection molded by using the mold insert; and wherein for the optical module assembly provided with the first structure or the second structure, the optical module fixing structure is injection molded by using different mold inserts of the set of mold inserts, such that a position and/or a dimension of the at least one optical module fastening component that is injection molded on the optical module fixing structure is configured to:
be suitable for mounting at least a part of the optical module assembly provided with the first structure onto the housing according to the optical module assembly provided with the first structure; or
be suitable for mounting at least a part of the optical module assembly provided with the second structure onto the housing according to the optical module assembly provided with the second structure.

8. A projection device, comprising:
the housing according to any one of claims 1 to 7; and
an optical module assembly mounted onto the housing.

9. A method for manufacturing a housing for a projection device, wherein the projection device comprises an optical module assembly, the housing comprises a main body structure and an optical module fixing structure, and the optical module fixing structure comprises at least one optical module fastening component to mount at least a part of the optical module assembly onto the housing; and the method comprises:
providing a mold main body for injection molding the main body structure of the housing;
selecting a mold insert for injection molding the optical module fixing structure according to a structure of the optical module assembly to be mounted onto the housing, wherein the mold insert is configured such that, when embedded into the mold main body, a position and/or a dimension of the at least one optical module fastening component that is injection molded on the optical module fixing structure is configured to be suitable for mounting the optical module assembly onto the housing;
embedding the selected mold insert into the mold main body to form an integral mold; and
injection molding the housing through the integral mold.

10. The method according to claim 9, wherein the optical module assembly is provided with a first structure or a second structure, and the second structure is different from the first structure; and wherein providing the mold main body for injection molding the main body structure of the housing, comprises:
for the optical module assembly provided with the first structure or the second structure, providing a same mold main body for injection molding the main body structure of the housing.

11. The method according to claim 9 or 10, wherein the optical module assembly is provided with a first structure or a second structure, and the second structure is different from the first structure; and wherein selecting the mold insert for injection molding the optical module fixing structure comprises:
selecting a first mold insert according to the optical module assembly provided with the first structure, wherein the first mold insert is configured such that, when embedded into the mold main body, a position and/or a dimension of the at least one optical module fastening component that is injection molded on the optical module fixing structure is configured to be suitable for mounting the optical module assembly provided with the first structure onto the housing; or
selecting a second mold insert according to the optical module assembly provided with the second structure, wherein the second mold insert is configured such that, when embedded into the mold main body, a position and/or a dimension of the at least one optical module fastening component after injection molding on the optical module fixing structure is configured to be suitable for mounting the optical module assembly provided with the second structure onto the housing.

12. A projection device, comprising:
a housing assembly, wherein the housing assembly comprises an upper housing and a lower housing, and the upper housing and the lower housing are detachably connected together;
an optical module assembly, wherein the optical module assembly is mounted onto the lower housing and separated from the upper housing; and
a speaker module, wherein the speaker module is mounted onto the upper housing and separated from the lower housing.

13. The projection device according to claim 12, wherein the upper housing is provided with a speaker buffer pad and a fastener, and the fastener mounts the speaker module onto the upper housing via the speaker buffer pad, such that the speaker module is spaced apart from the upper housing by the speaker buffer pad.

14. The projection device according to claim 12 or 13, wherein a lower housing buffer pad is disposed on an outer surface of the lower housing.

15. The projection device according to claim 12 or 13, wherein an elastic sealing member is disposed between the upper housing and the lower housing.

16. The projection device according to claim 12 or 13, wherein the optical module assembly is provided with a counterweight.

17. The projection device according to claim 12 or 13, wherein the speaker module comprises a speaker main body and at least one passive low-frequency radiator.

18. The projection device according to claim 17, wherein the speaker module comprises two passive low-frequency radiators disposed on left and right sides of the speaker main body, respectively.

19. A method for a projection device, wherein the projection device comprises: an optical module assembly, wherein the optical module assembly comprises a light outlet for emitting projection light; and a first perception sensor and a second perception sensor; and the method comprises:
detecting, via the first perception sensor, whether an object appears in a first area in front of the light outlet;
detecting, via the second perception sensor, whether an object appears in a second area in front of the light outlet, wherein the first area is different from the second area; and
determining, based on a signal detected by at least one of the first perception sensor and the second perception sensor, an adjustment of projection of the optical module assembly.

20. The method according to claim 19, wherein at least one of the first perception sensor and the second perception sensor comprises one of an image acquisition unit, a single-point time-of-flight (TOF) sensor, a multi-point TOF sensor, and a passive infrared (PIR) sensor.

21. The method according to claim 19, wherein at least one of the first perception sensor and the second perception sensor comprises a single-point TOF sensor; and determining, based on a signal detected by the single-point TOF sensor, the adjustment of the projection of the optical module assembly, comprises:
determining, in response to the detected signal being less than a threshold, that the object is detected, wherein the detected signal is a distance between the single-point TOF sensor and the object; and
controlling, in response to detecting the object, the optical module assembly to reduce a light intensity of the emitted projection light.

22. The method according to claim 19, wherein at least one of the first perception sensor and the second perception sensor comprises a multi-point TOF sensor; and determining, based on a signal detected by the multi-point TOF sensor, the adjustment of the projection of the optical module assembly, comprises:
fitting a plane based on a point cloud formed by the detected signal;
calculating a distance from the point cloud to the fitted plane;
determining, in response to the distance being greater than a threshold, that the object is detected; and
controlling, in response to detecting the object, the optical module assembly to reduce a light intensity of the emitted projection light.

23. The method according to claim 19, wherein at least one of the first perception sensor and the second perception sensor comprises an image acquisition unit; and determining, based on a signal detected by the image acquisition unit, the adjustment of the projection of the optical module assembly, comprises:
performing frame synchronization with a projection picture of the optical module through a timestamp;
acquiring an image through the image acquisition unit and obtaining an optical module projection image at a corresponding time;
determining, in response to a difference between the image acquired by the image acquisition unit and the optical module projection image at the corresponding time being greater than a threshold, that the object is detected; and
controlling, in response to detecting the object, the optical module assembly to reduce a light intensity of the emitted projection light.

24. The method according to claim 19, wherein determining the adjustment of the projection of the optical module assembly, comprises:
determining, based on the signal detected by the at least one of the first perception sensor and the second perception sensor, a confidence that at least one of the first perception sensor and the second perception sensor detects the object;
determining, according to a position of at least one of the first perception sensor and the second perception sensor, the confidence that the object is detected, and an object position indicated by the detected signal, whether the object is detected based on a preset decision-making method;
recording a duration in which the object is detected; and
controlling, in response to determining that the object is detected and the duration being greater than a time threshold, the optical module assembly to reduce a light intensity of the emitted projection light.

25. The method according to claim 24, wherein at least one of the first perception sensor and the second perception sensor comprises a single-point TOF sensor; and determining, based on the signal detected by the at least one of the first perception sensor and the second perception sensor, the confidence that the at least one of the first perception sensor and the second perception sensor detects the object, comprises:
setting the confidence of the single-point TOF sensor to 100% based on the signal detected by the single-point TOF sensor.

26. The method according to claim 24, wherein at least one of the first perception sensor and the second perception sensor comprises a multi-point TOF sensor; and determining, based on the signal detected by the at least one of the first perception sensor and the second perception sensor, the confidence that the at least one of the first perception sensor and the second perception sensor detects the object, comprises:
calculating the confidence that the multi-point TOF sensor detects the object according to a number of points, dispersion, and enclosing area of a point cloud formed by the signal detected by the multi-point TOF sensor.

27. The method according to claim 24, wherein at least one of the first perception sensor and the second perception sensor comprises an image acquisition unit; and determining, based on the signal detected by the at least one of the first perception sensor and the second perception sensor, the confidence that the at least one of the first perception sensor and the second perception sensor detects the object, comprises:
determining a size of a non-projection picture and a difference between images according to the signal detected by the image acquisition unit; and
calculating the confidence that the image acquisition unit detects the object based on the size of the non-projection picture and the difference between the images.

28. The method according to claim 24, wherein determining whether the object is detected based on the preset decision-making method, comprises:
determining a first weight value of a confidence that the first perception sensor detects the object;
determining a second weight value of a confidence that the second perception sensor detects the object;
determining a total confidence that the object is detected based on the first weight value and the second weight value; and
determining, based on the total confidence, whether the object is detected.

29. The method according to claim 19 or 20, wherein the first area is tangent to or overlaps the second area.

30. The method according to claim 19 or 20, wherein the projection device further comprises an ambient light sensor disposed adjacent to the light outlet, and the ambient light sensor detects brightness and/or color of ambient light; and the method further comprises:
adjusting an intensity of at least one color in the projection light emitted by the optical module assembly according to the brightness and/or the color of the ambient light detected by the ambient light sensor, thereby adjusting a color temperature and/or white balance of a projected picture.

31. The method according to claim 19 or 20, further comprising:
enabling the projection device to give a warning sound or display prompt information on a projected picture in response to at least one of the first perception sensor and the second perception sensor detecting that the object appears in front of the light outlet.

32. The method according to claim 19 or 20, wherein the first perception sensor and the second perception sensor are disposed adjacent to the light outlet.

33. The method according to claim 19 or 20, wherein the first perception sensor and the second perception sensor are disposed on left and right sides of the light outlet, respectively.

34. A projection device, comprising:
an optical module assembly, wherein the optical module assembly comprises a light outlet for emitting projection light;
a first perception sensor, wherein the first perception sensor is configured to detect whether an object appears in a first area in front of the light outlet;
a second perception sensor, wherein the second perception sensor is configured to detect whether an object appears in a second area in front of the light outlet, wherein the first area is different from the second area; and
at least one processor, wherein the at least one processor is configured to execute instructions to perform the method according to any one of claims 19 to 33.

35. A projection device, comprising:
a housing, wherein the housing comprises an air inlet and an air outlet, and the air inlet and the air outlet are formed in opposite sides of the housing;
an optical module assembly, wherein the optical module assembly is disposed in the housing and located on a straight line between the air inlet and the air outlet; and
a fan, wherein the fan is disposed between the air inlet and the air outlet and configured such that a generated airflow flows through the housing in a direction of the straight line between the air inlet and the air outlet.

36. The projection device according to claim 35, further comprising:
a heat sink, wherein the heat sink is thermally coupled to the optical module assembly and comprises heat dissipation fins,
wherein the airflow generated by the fan flows through the heat dissipation fins.

37. The projection device according to claim 36, further comprising:
a first sealing member, wherein the first sealing member is disposed at a gap between the fan and the heat sink, such that a closed airflow flow channel is formed between the fan and the heat sink; and/or
a second sealing member, wherein the second sealing member is disposed between the heat dissipation fins and the air outlet, such that a closed airflow channel is formed between the heat dissipation fins and the air outlet.

38. The projection device according to claim 37, wherein the sealing member comprises a sealing tape.

39. The projection device according to any one of claims 35 to 38, wherein the optical module assembly comprises at least two sets of light sources; and wherein the projection device further comprises at least one heat pipe, the at least one heat pipe connecting at least one of the at least two sets of light sources to the heat sink to transfer heat from the at least one set of light sources to the heat sink.
